# EUROPEAN PATENT APPLICATION

(11) **EP 2 640 068 A2**
(43) Date of publication of application: **18.09.2013**
(21) Application number: 13156724.0
(22) Date of filing: 26.02.2013
(51) Int. Cl.: H04N 5/369

(54) **Imaging apparatus and image sensor thereof**

(30) Priority: 15.03.2012 KR 20120026567
(71) Applicant: Samsung Electronics Co., Ltd., Gyeonggi-do 443-742 (KR)
(72) Inventor: Choi, Woo-seok, Seoul (KR)
(74) Representative: Waddington, Richard

(57) **Abstract**

An imaging apparatus and an image sensor, where the imaging apparatus includes a lens unit and an image sensor including a plurality of image detection pixels for detecting an image formed by the lens unit and a plurality of focus detection pixels for detecting a focus of the image, wherein the plurality of focus detection pixels are arranged in a non-uniform pattern in which arrangements within shared intervals between the plurality of focus detection pixels are not equal to each other. Accordingly, the focus of an image formed on the image sensor can be accurately measured while a loss of image quality of the image formed on the image sensor is minimized.

## Description

### PRIORITY

This application claims priority to Korean Patent Application No. 10-2012-0026567, which was filed on March 15, 2012, in the Korean Intellectual Property Office, the entire disclosure of which is incorporated herein by reference.

### BACKGROUND OF THE INVENTION

### 1. Field of the invention

The present invention relates generally to an imaging apparatus and an image sensor thereof, and more particularly, to an imaging apparatus and an image sensor thereof, which detect focus of an image formed by a lens unit using a phase difference between pixels for detecting the focus provided in the image sensor.

### 2. Description of the Related Art

When capturing an image using an imaging apparatus, properly detecting the focus of an image formed by a lens unit is important. In the related art, a method for detecting the focus of an image using a mirror for detecting the focus has been used. However, the method for detecting the focus of the image using the mirror for detecting the focus additionally requires to include the mirror for detecting the focus in the main body of the imaging apparatus, and thus adding bulk to the imaging device, which becomes thick and large-sized.

In order to solve this problem, a method for detecting the focus of an image using a phase difference between pixels for detecting the focus provided in the image sensor has been recently used. Specifically, positions of micro lenses of focus detection pixels arranged in an image sensor are set differently from reference positions of micro lenses of general image detection pixels, a light shielding film is installed on one side in a cavity of the focus detection pixels, or photo diode regions of the focus detection pixels lean to one side. In these cases, the focus detection pixels only detect light that passes through one side of an image-forming lens.

As described above, if first focus detection pixel (AF1 pixels) that detect light passing through one side of the image forming lens and second focus detection pixels (AF2 pixels) that detect light passing through the other side of the image forming lens are arranged in the image sensor, the imaging apparatus can detect the focus state of the image through comparison of phases of the image according to the pixels for detecting the first focus and the image according to the pixels for detecting the second focus.

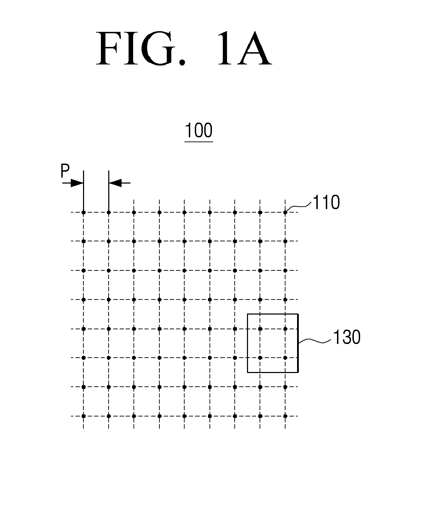

That is, according to the method for detecting the focus of the image using the focus detection pixels, it is very important to arrange the focus detection pixels in a manner which prevents a loss of the image quality of the image in the image sensor including the focus detection pixels. In an image sensor 100 in the related art, illustrated in FIG. 1A, focus detection pixels 110 are periodically arranged through dropping of the pixels at predetermined intervals P.

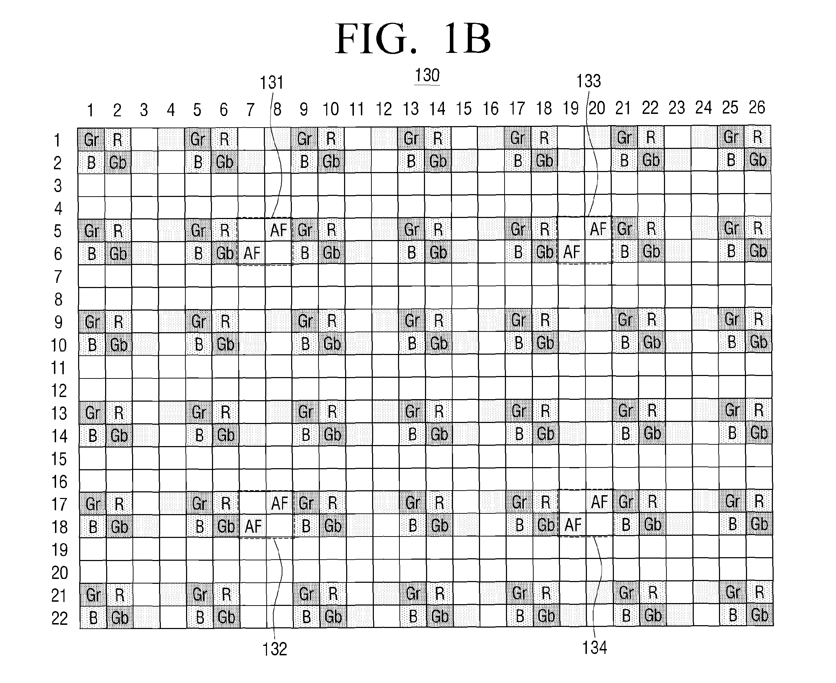

FIG. 1B is a diagram illustrating a specified area 130 of the image sensor 100 of FIG. 1A. As illustrated in FIG. 1B, focus detection pixels 131, 132, 133, and 134 are regularly arranged at constant intervals (for example, 12 pixels).

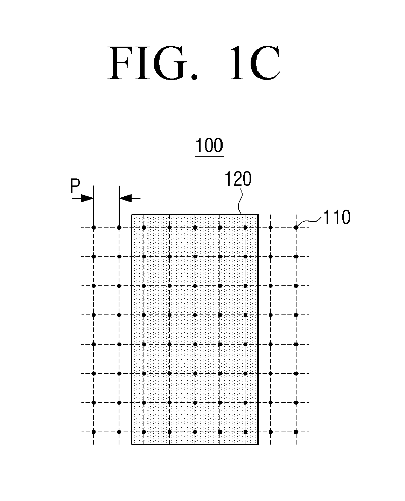

However, as illustrated in FIG. 1C, there is a long distance between the focus detection pixels when the boundary of an object 120 is clear. Because the distance between the boundary of the object 120 and the focus detection pixels is long, this results in problems in detecting the focus of the image when the boundary of the object is clear.

Further, if the distance between the focus detection pixels is shortened in order to detect the focus of the image more clearly, the focus state of the image can be accurately detected, which requires many focus detection pixels, and causes a problem in that the image quality of the image formed on the image sensor deteriorates.

Accordingly, there is a need for an image sensor which can detect the focus of an image to be captured more accurately while minimizing the number of focus detection pixels that deteriorate the image quality of the image.

### SUMMARY OF THE INVENTION

Accordingly, the present invention has been made to solve the above problems and/or disadvantages occurring in the prior art. Accordingly, an aspect of the present invention provides an imaging apparatus and an image sensor thereof, which can accurately measure the focus of an image formed on the image sensor while minimizing a loss of image quality of the image formed on the image sensor.

According to the present invention there is provided an apparatus and method as set forth in the appended claims. Other features of the invention will be apparent from the dependent claims, and the description which follows.

According to one aspect of the present invention, there is provided an imaging apparatus which includes a lens unit, and an image sensor in which a plurality of image detection pixels for detecting an image formed by the lens unit and a plurality of focus detection pixels for detecting a focus of the image, wherein the plurality of focus detection pixels are arranged in a non-uniform pattern in which arrangements within shared intervals between the plurality of focus detection pixels are not equal to each other.

According to another aspect of the present invention, there is provided an image sensor for converting an image formed by a lens unit into an electrical signal which includes a plurality of image detection pixels for detecting the image formed by the lens unit, and a plurality of focus detection pixels for detecting a focus of the image, wherein the plurality of focus detection pixels are arranged in a non-uniform pattern in which arrangements within shared intervals between the plurality of focus detection pixels are not equal to each other.

According to still another aspect of the present invention, there is provided an imaging apparatus which includes a lens unit, and an image sensor including a plurality of focus detection pixels for detecting a focus of an image formed by a lens unit and converting the image formed by the lens unit into an electrical signal, wherein the plurality of focus detection pixels are arranged in a predetermined range based on reference pixels arranged at predetermined intervals in the image sensor.

According to still another aspect of the present invention, an image sensor for converting an image formed by a lens unit into an electrical signal includes a plurality of image detection pixels for detecting the image formed by the lens unit, and a plurality of focus detection pixels for detecting a focus of the image, wherein the plurality of focus detection pixels are arranged in a predetermined range based on reference pixels arranged at predetermined intervals in the image sensor.

### BRIEF DESCRIPTION OF THE DRAWINGS

The above and other aspects, features and advantages of the present invention will be more apparent from the following detailed description, taken in conjunction with the accompanying drawings, in which:
FIGS. 1A to 1C are diagrams illustrating a conventional image sensor that includes focus detection pixels;
FIG. 2 is a block diagram illustrating the configuration of an imaging apparatus according to an embodiment of the present invention;
FIGS. 3A and 3B are diagrams illustrating various focus detection pixels according to embodiments of the present invention;
FIGS. 4A and 4B are diagrams illustrating an image sensor including focus detection pixels according to an embodiment of the present invention;
FIG. 5 is a diagram illustrating a method for arranging focus detection pixels of an image sensor according to an embodiment of the present invention;
FIG. 6 is a diagram illustrating a graph comparing focus detection performances of a regular arrangement of focus detection pixels in the related art and a non-uniform arrangement of focus detection pixels according to the present invention; and
FIG. 7 is a diagram illustrating an example of an object having a clear boundary in order to compare focus detection performances in the related art and according to the present invention.

### DETAILED DESCRIPTION OF EMBODIMENTS OF THE PRESENT INVENTION

Hereinafter, various embodiments of the present invention are described in more detail with reference to the accompanying drawings, in which aspects of the present invention are illustrated.

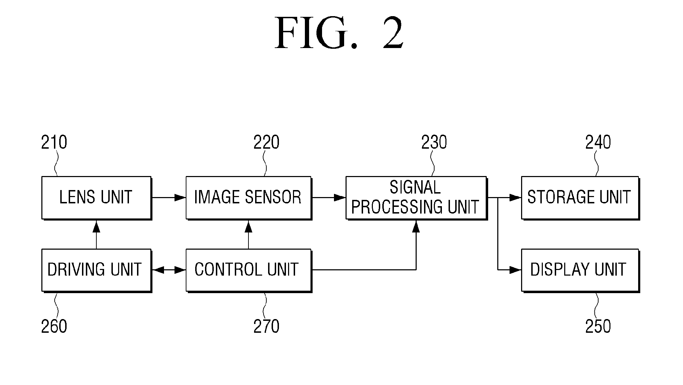

FIG. 2 is a block diagram illustrating the configuration of an imaging apparatus 200 according to an embodiment of the present invention. As illustrated in FIG. 2, the imaging apparatus 200 includes a lens unit 210, an image sensor 220, a signal processing unit 230, a storage unit 240, a display unit 250, a driving unit 260, and a control unit 270.

The lens unit 210 includes a zoom lens capable of expanding or reducing the size of an object, a focus lens adjusting the focus of the object, and an iris adjusting light quantity, and receives a light signal from an external object.

The image sensor 220 converts the light signal of the object incident through the lens unit 210 into an electrical signal and outputs the electrical signal. The image sensor 220 includes a plurality of image detection pixels for detecting the image formed by the lens unit 210 and a plurality of focus detection pixels for detecting the focus of the image formed by the lens unit 210.

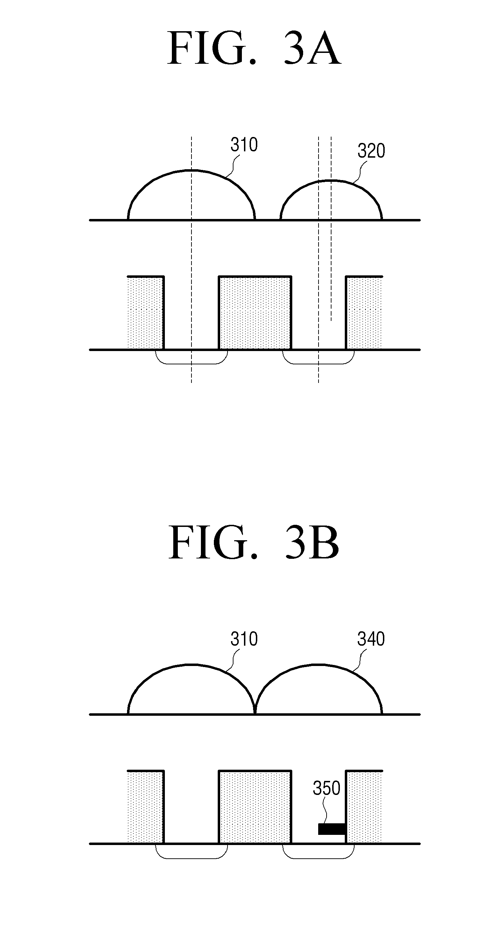

FIGS. 3A and 3B are diagrams illustrating various focus detection pixels according to embodiments of the present invention. According to an embodiment of the present invention, as illustrated in FIG. 3A, optical axes of lenses of the focus detection pixels 320 are configured to lean to one side as compared with the optical axes of lenses of the general image detection pixels 310. By configuring the optical axes of the lenses of the focus detection pixel 320 differently from the optical axes of the lenses of the general image detection pixel 310, the focus detection pixels only detect light that passes in one direction of the lens unit 210.

Further, according to an embodiment of the present invention, the optical axes of the lenses of the focus detection pixels 340 and the optical axes of the lenses of the general image detection pixels 330 are equal to each other, and a light shielding film 350 is configured on one side surface of a cavity. By configuring the light shielding film 350 on one side surface of the focus detection pixels 340, the focus detection pixels only detect the light that passes in one direction of the lens unit 210.

However, the focus detection pixels 340 as illustrated in FIGS. 3A and 3B may alternatively be detected by another method, for example by only detecting the light that passes in one direction of the lens unit 210, by configuring photo diode regions of the focus detection pixels, in which photoelectric conversion occurs, to lean to one side. Thus, the focus detection pixels only detect the light that passes in one direction of the lens unit.

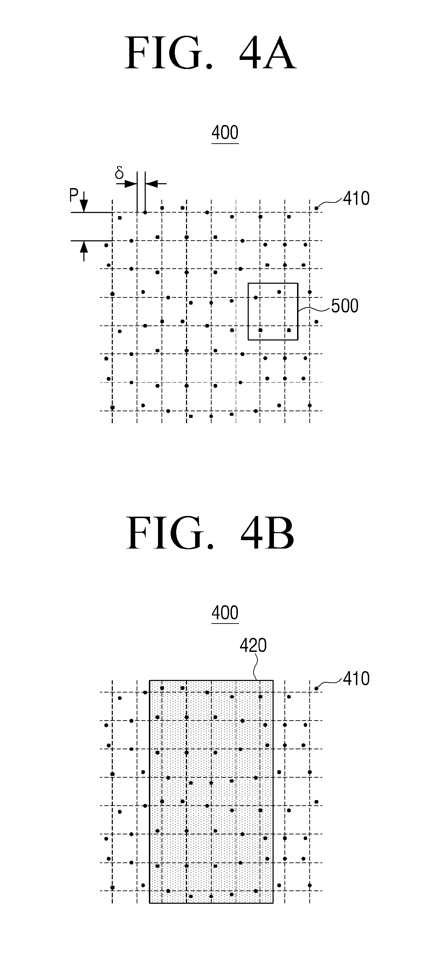

Further, the image sensor 220 includes a pair of focus detection pixels including first focus detection pixels (AF1 pixels) for detecting the light passing through one side of the lens unit 210 and second focus detection pixels (AF2 pixels) for detecting the light passing through the other side of the lens unit 210. The detailed methods for arranging the focus detection pixels in the image sensor 220 are described in more detail with reference to FIGS. 4A to 6.

The signal processing unit 230 performs signal processing, such as gain adjustment, noise removal, gamma correction, luminance signal separation, image signal compression, and the like, with respect to the electrical signal output from the image sensor 220. The signal-processing unit 230 displays the processed image on the display unit 250 or stores the processed image in the storage unit 240. Here, the display unit 250 includes a viewfinder positioned on a main body of the imaging apparatus 200.

The driving unit 260 drives the lens unit 210 to match the focus of the image in accordance with a driving control signal generated by the control unit 270.

The control unit 270 controls the overall operation of the imaging apparatus 200 in accordance with a user input.

That is, the control unit 270 detects the focus state of the image by comparing the phase of the image acquired by the first focus detection pixel included in the image sensor 220 with the phase of the image acquired by the second focus detection pixel. Then, the control unit 270 generates a lens control drive signal based on the detected focus state, and outputs the lens control drive signal to the driving unit 260 for driving the lens unit 210.

Hereinafter, a method for arranging focus detection pixels in the image sensor 220 is described in more detail with reference to FIGS. 4A to 6.

FIGS. 4A and 4B are diagrams illustrating an image sensor including focus detection pixels according to an embodiment of the present invention. That is, the focus detection pixels 410 are arranged in a non-uniform pattern in which arrangements within shared intervals between the focus detection pixels are not equal to each other in the image sensor 400.

The focus detection pixel 410 is arranged as spaced apart for a predetermined distance δ in a predetermined direction from a reference pixel position that is apart at a predetermined interval P. The predetermined direction is a diagonal direction in addition to up, down, right and left directions.

Further, the predetermined distance δ differs depending on the operating method of the imaging apparatus 200 as operating in a sampling mode. The sampling mode refers to a mode that requires a high frame rate for imaging, and is a mode in which a live view of the imaging apparatus is displayed or a mode in which an auto focusing operation is performed. In the sampling mode, there is a 2R2S method (2 pixel read 2 pixel skip mode) for reading two image detection pixels from four successive image detection pixels and skipping two image detection pixels and a 1 R2S method (1 pixel read 2 pixel skip mode) for reading one image detection pixel from three successive image detection pixels and skipping two image detection pixels.

If the sampling mode is the 2R2S method, four successive image detection pixels are repeated, and thus the predetermined distance δ, that is the distance for which the focus detection pixel 410 is apart from the reference pixel position, corresponds to four pixels. If the sampling mode is the 1 R2S method, six successive image detection pixels are repeated, and thus the predetermined distance δ that is the distance corresponds to six pixels.

As illustrated in FIG. 4A, the predetermined distance δ is constant. However, alternatively, the distance δ may differ depending on the plurality of focus detection pixels 410. For example, if the sampling mode is the 2R2S method, the predetermined distance δ is a distance within four pixels, and if the sampling mode is the 1 R2S method, the predetermined distance δ is a distance within six pixels.

Because the focus detection pixels 410 are arranged in a non-uniform pattern in which arrangements within shared intervals between the focus detection pixels are not equal to each other in the image sensor 400, as illustrated in FIG. 4B, the distance between the boundary of the object 420 and the focus detection pixel 410 is reduced even if the boundary of the object 420 is clear, and thus the focus of the image can be detected more accurately.

Further, since the focus detection pixels 410, from which no image is detected, are arranged in a non-uniform pattern, the deterioration of the image quality of the image captured through the focus detection pixels 410 can be minimized as compared to a case where the focus detection pixels 410 are regularly arranged at constant intervals.

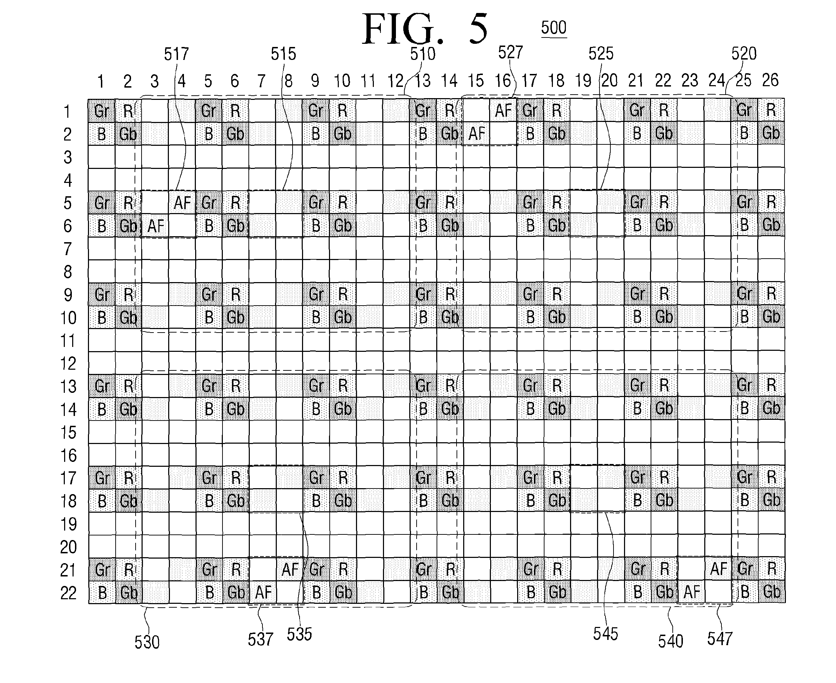

FIG. 5 is a diagram illustrating the focus detection pixels when the image sensor 220 operates in the sampling mode in the 2R2S method. Specifically, in FIG. 5 the one region 500 illustrated in FIG. 4A has been enlarged. A pixel in which Gr, Gb, R, and B is described as an image detection pixel that is read during operation in the sampling mode, a pixel in which AF is described is a focus detection pixel, and the remaining pixels are image detection pixels that are skipped during the operation in the sampling mode.

As illustrated in FIG. 5, the image sensor 220 is divided into a plurality of regions 510, 520, 530, and 540, and reference pixel positions 515, 525, 535, and 545 are present in the center, inside of the plurality of regions. According to an embodiment of the present invention, the reference pixel positions 515, 525, 535, and 545 are arranged at an interval of 12 pixels. In order to detect the focus of the image, two focus detection pixels are present in the image sensor 220 as a pair. Hereinafter, for illustration purposes, a pair of focus detection pixels is considered as one focus detection pixel.

The focus detection pixels 517, 527, 537, and 547 are arranged in positions that are apart for a predetermined distance (for example, four pixels) in a predetermined direction from the reference pixel positions. For example, in the first region 510, the focus detection pixel 517 is arranged in a position that is apart for four pixels from the reference pixel position 515 in the left direction, and in the second region 520, the focus detection pixel 527 is arranged in a position which is apart for four pixels from the reference pixel position 525 in the left direction and is apart for four pixels in the upward direction. Further, in the third region 530, the focus detection pixel 537 is arranged in a position that is apart for four pixels from the reference pixel position 535 in the downward direction, and in the fourth region 540, the focus detection pixel 547 is arranged in a position which is apart for four pixels from the reference pixel position 545 in the right direction and is apart for four pixels in the downward direction.

In order to prevent the deterioration of the image quality of the captured image, the focus detection pixel is arranged in a position in which an R pixel is arranged and in a position in which a B pixel is arranged rather than in a position in which a G pixel is arranged.

Further, the focus detection pixels 517, 527, 537, and 547 are arranged in pixel lines in which the image detection pixels, that are read to detect the image formed by the lens unit 210 in the sampling mode operation, are arranged. For example, the focus detection pixel 517 arranged in the first region 510 is arranged in fifth and sixth pixel lines in which image detection pixels that are read in the sampling mode are arranged. Further, the remaining focus detection pixels 527, 537, and 547 are also arranged in the pixel lines in which image detection pixels that are read in the sampling mode are arranged.

Further, the focus detection pixels are not arranged on pixels for detecting the image formed by the lens unit 210 during the sampling mode operation. That is, the pixel positions in which the focus detection pixels can be arranged are positions of the image detection pixels that are not read during the sampling mode operation.

As described above, the focus detection pixels are not arranged in the pixel positions in which image detection pixels that are read during the sampling mode operation are arranged, but are arranged in the pixel lines in which the image detection pixels are arranged. Accordingly, the image quality of the image during the sampling operation is not deteriorated, and readout circuit for reading the pixels can be minimized.

Although the reference pixel positions are arranged at an interval of 18 pixels in FIG. 5, the reference pixel positions may alternatively be arranged at an interval of 10 pixels or 20 pixels. For example, if the sampling mode is the 1 R2S method, the reference pixel positions are arranged at an interval of 18 pixels.

Further, although the focus detection pixels are arranged to be space apart for a predetermined distance (four pixels) from the reference pixel positions as illustrated in FIG. 5, alternatively, the focus detection pixels can also be arranged in a predetermined position in the region rather than be spaced a predetermined distance apart from the reference pixel positions.

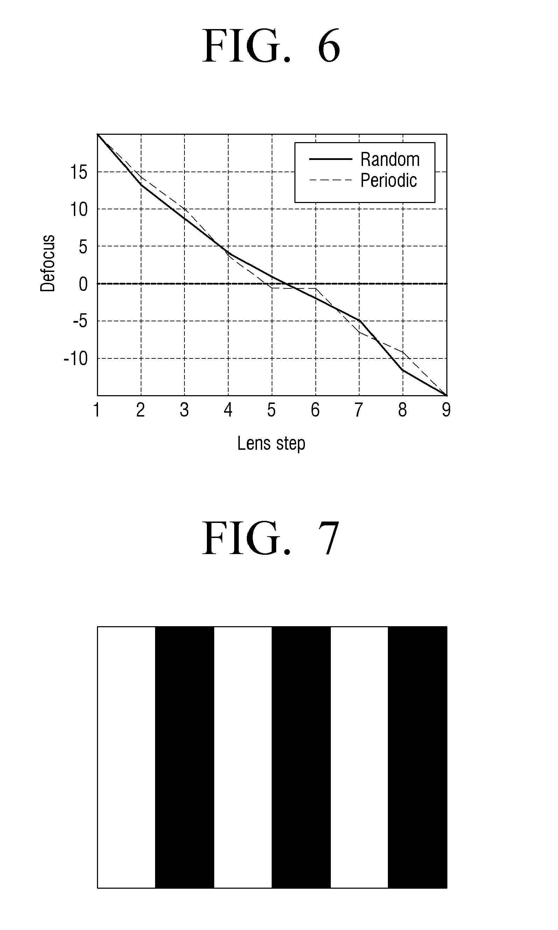

FIG. 6 is diagram illustrating a graph showing the focus detection performance according to an embodiment of the present invention in the case of using the image sensor including the focus detection pixels formed in a non-uniform pattern.

That is, FIG. 6 is diagram illustrating a graph for comparing defocus values when the focus detection pixels are arranged in a period of 18 pixels as illustrated in FIG. 1A and when the reference pixel positions are arranged in a period of 18 pixels and the focus detection pixels are arranged in a non-uniform pattern as illustrated in FIG. 4A, in a state where the boundary of the object indicates a clear vertical line as illustrated in FIG. 7.

Specifically, as illustrated in FIG. 1A, when the focus detection pixels are arranged in a predetermined period (indicated by a dotted line), the imaging apparatus 200 is unable to detect the point in which the defocus value becomes "0" from one spot, but detects the point in which the defocus value becomes "0" in various ranges 5 to 6. Accordingly, if the focus detection pixels are arranged in a predetermined period when capturing an image of the object having distinctive boundary, it is difficult for the imaging apparatus to accurately detect the focus of the image.

However, as illustrated in FIG. 4A, if the focus detection pixels are arranged in a non-uniform pattern (indicated by a solid line), the point in which the defocus value of the imaging apparatus becomes "0" can be detected from one spot (in the vicinity of 5.5). Accordingly, the imaging apparatus 200 can accurately control the lens unit 210 to match the focus of the image.

As described above, according to an embodiment of the present invention, since the focus detection pixels are irregularly arranged, the focus of the image formed on the image sensor can be accurately measured while a loss of the image quality of the image formed on the image sensor is minimized.

Although it is described that all regions are illustrated as different patterns in FIG. 4A, alternatively, pixel patterns in a plurality of regions can be formed in equal units of a predetermined number of regions. For example, pixel patterns in four regions illustrated in FIG. 5 can be repeatedly formed in a plurality of regions.

While the present invention has been shown and described with reference to various embodiments thereof, it will be understood by those skilled in the art that various changes in form and detail may be made without departing from the scope of the present invention, as defined by the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An imaging apparatus comprising:
a lens unit; and
an image sensor including a plurality of image detection pixels for detecting an image formed by the lens unit and a plurality of focus detection pixels for detecting a focus of the image,
wherein the plurality of focus detection pixels are arranged in a non-uniform pattern in which arrangements within shared intervals between the plurality of focus detection pixels are not equal to each other.

2. The imaging apparatus as claimed in claim 1, wherein the image sensor is divided into a plurality of regions,
the plurality of focus detection pixels are spaced a predetermined distance in a predetermined direction apart from reference pixel positions in the respective plurality of regions, and
the plurality of image detection pixels are arranged in the remaining positions in the respective plurality of regions.

3. The imaging apparatus as claimed in claim 2, wherein pixel patterns in the plurality of regions are formed in equal units of a predetermined number of regions.

4. The imaging apparatus as claimed in any one of claims 1 to 3, wherein the focus detection pixels are arranged in pixel lines, in which the image detection pixels for detecting the image formed by the lens unit are arranged, when the imaging apparatus operates in a sampling mode, and
the sampling mode includes a mode in which a live view of the imaging apparatus is displayed and an auto focusing operation is performed.

5. The imaging apparatus as claimed in claim 4, wherein the focus detection pixels are arranged in different positions from the pixels for detecting the image formed by the lens unit when the imaging apparatus operates in the sampling mode.

6. The imaging apparatus as claimed in any one of claims 2 to 5, wherein reference pixel positions are continuously arranged at an interval of 10 pixels to 20 pixels.

7. The imaging apparatus as claimed in claim 6, wherein when the imaging apparatus uses only two of four successive image capturing pixels in the sampling mode, the reference pixel positions in the plurality of regions are periodically arranged every 12 pixels.

8. The imaging apparatus as claimed in claim 6, wherein when the imaging apparatus uses only one of three successive image capturing pixels in the sampling mode, the reference pixel positions in the plurality of regions are periodically arranged every 18 pixels.

9. The image sensor included in an imaging apparatus as claimed in any one of claims 1 to 8.
